# EUROPEAN PATENT APPLICATION

(11) **EP 2 916 154 A1**
(43) Date of publication of application: **09.09.2015**
(21) Application number: 15157490.2
(22) Date of filing: 04.03.2015
(51) Int. Cl.: G02B 7/18, G02B 26/08

(54) **Projector**

(30) Priority: 07.03.2014 JP 2014045313
(71) Applicant: Funai Electric Co., Ltd., Daito-shi, Osaka 574-0013 (JP)
(72) Inventor: Kobyashi, Tomohiro, Daito-shi Osaka 574-0013 (JP)
(74) Representative: Grünecker Patent- und Rechtsanwälte PartG mbB

(57) **Abstract**

This projector (100) includes a light source portion (71a, 71b, 71c) applying a laser beam, an oscillating mirror element (1, 2) scanning light and a conductive member (5, 6) supporting the oscillating mirror element, and makes the conductive member generate heat by applying power to the conductive member.

## Description

### BACKGROUND OF THE INVENTION

### Field of the Invention

The present invention relates to a projector, and more particularly, it relates to a projector including an oscillating mirror element.

### Description of the Background Art

A projector including an oscillating mirror element is known in general, as disclosed in Japanese Patent Laying-Open No. 2011-69860.

The aforementioned Japanese Patent Laying-Open No. 2011-69860 discloses a projector including a light source portion, an oscillating mirror element including a mirror portion and a shaft portion supporting the mirror portion for scanning light and a conductive member supporting the oscillating mirror element. The conductive member of the projector is provided with a heating coil and a coil terminal. The projector is configured to increase the temperature of the oscillating mirror element (the shaft portion) by increasing the temperature of the conductive member with the heating coil. The temperature of the oscillating mirror element (the shaft portion) is so increased as to keep the resonance frequency of the oscillating mirror element constant and to stabilize swinging of the mirror portion. When such an oscillating mirror element is driven at a high speed under a high-temperature environment in general, a shaft portion may be condensed. When the temperature of the oscillating mirror element (the shaft portion) is increased as in the aforementioned Japanese Patent Laying-Open No. 2011-69860, therefore, the shaft portion can conceivably be prevented from condensation.

In the projector according to the aforementioned Japanese Patent Laying-Open No. 2011-69860, however, the heating coil and the coil terminal must be separately provided on the conductive member in order to increase the temperature of the oscillating mirror element, and hence the structure for increasing the temperature of the oscillating mirror element is disadvantageously complicated.

### SUMMARY OF THE INVENTION

The present invention has been proposed in order to solve the aforementioned problem, and an object of the present invention is to provide a projector capable of increasing the temperature of an oscillating mirror element in a simple structure.

A projector according to an aspect of the present invention includes a light source portion applying light, an oscillating mirror element scanning the light and a conductive member supporting the oscillating mirror element, and makes the conductive member generate heat by applying power to the conductive member.

As hereinabove described, the projector according to the aspect of the present invention is provided with the conductive member for supporting the oscillating mirror element and makes the conductive member generate heat by applying power thereto. Thus, the projector directly applies power to the conductive member, whereby no heating coil or the like may be separately provided. Consequently, the temperature of the oscillating mirror element can be increased in a simple structure, without complicating the structure for increasing the temperature of the oscillating mirror element.

The aforementioned projector according to the aspect preferably further includes a wiring board, electrically connected to the oscillating mirror element, including a first wiring portion transmitting a driving signal to the oscillating mirror element and a second wiring portion different from the first wiring portion, and applies power to the conductive member through the second wiring portion of the wiring board. According to this structure, the projector can transmit the driving signal to the oscillating mirror element and apply power to the conductive member with the single wiring board due to the provision of the second wiring portion on the wiring board including the existing first wiring portion, whereby the temperature of the oscillating mirror element can be increased in a simple structure without complicating the device structure, also according to this.

In the aforementioned projector according to the aspect, the conductive member is preferably made of conductive resin containing a conductive substance. According to this structure, the conductive member can be easily formed by resin molding.

In the aforementioned projector according to the aspect, the oscillating mirror element preferably includes a mirror portion reflecting the light and a shaft portion swingably supporting the mirror portion, and a position of the conductive member corresponding to the shaft portion preferably generates heat when current flows to the position corresponding to the shaft portion. According to this structure, the conductive member generates heat around a prescribed position corresponding to the shaft portion of the oscillating mirror element, whereby the temperature of the easily condensed shaft portion of the oscillating mirror element can be increased through the conductive member. Consequently, the shaft portion can be effectively prevented from condensation.

In this case, the oscillating mirror element preferably includes an interdigitally formed fixed electrode portion provided in the vicinity of the shaft portion, while the shaft portion preferably has an interdigitally formed movable electrode portion, and preferably swings due to electrostatic force generated between the movable electrode portion and the fixed electrode portion. In the electrostatically driven oscillating mirror element having interdigital electrodes, interdigits of the movable and fixed electrode portions are arranged in proximity to each other, and hence the shaft portion is more easily condensed as compared with an oscillating mirror element driven by another system. In the electrostatically driven oscillating mirror element, the shaft portion can be effectively prevented from condensation due to the aforementioned structure.

In the aforementioned structure in which the oscillating mirror element includes the mirror portion and the shaft portion, a planar portion is preferably formed on a region of the conductive member corresponding to a position where the shaft portion of the oscillating mirror element is arranged in plan view, recess portions are preferably formed on regions adjacent to the planar portion in plan view, and the thickness of the conductive member in the recess portions is preferably smaller than the thickness of the conductive member in the planar portion. According to this structure, a sectional area orthogonal to the shaft portion is larger (electric resistance is smaller) in the planar portion as compared with the recess portions, whereby current easily flows to the planar portion of the conductive member corresponding to the shaft portion of the oscillating mirror element. Thus, the temperature of the shaft portion of the oscillating mirror element can be efficiently increased.

In the aforementioned structure in which the planar portion and the recess portions are formed on the conductive member, the planar portion is preferably formed to extend in an axial direction along the shaft portion, while the recess portions are preferably formed to extend in the axial direction and arranged on both sides of the planar portion adjacently to the planar portion to hold the planar portion therebetween. According to this structure, the recess portions are arranged on both sides of the planar portion, whereby the temperature of the shaft portion of the oscillating mirror element can be more efficiently increased as compared with a case where the recess portions are arranged on one side of the planar portion.

The aforementioned projector according to the aspect preferably further includes a wiring board, electrically connected to the oscillating mirror element, including a first wiring portion transmitting a driving signal to the oscillating mirror element and a second wiring portion different from the first wiring portion, the wiring board is preferably arranged on the conductive member and supported by the conductive member, and the projector preferably applies power to the conductive member through the second wiring portion of the wiring board. According to this structure, the conductive member supports the wiring board, whereby the wiring board can be stably arranged with respect to the oscillating mirror element, while the projector can easily apply power to the conductive member provided in close vicinity to the wiring board through the second wiring portion of the wiring board.

In this case, the wiring board preferably includes an upper-side covering portion covering an upper side of the second wiring portion, a lower-side covering portion arranged on a side of the second wiring portion closer to the conductive member for covering a lower side of the second wiring portion and an exposing portion exposing the second wiring portion not covered with at least one of the upper-side covering portion and the lower-side covering portion, and the second wiring portion is preferably electrically connected with the conductive member through the exposing portion. According to this structure, the second wiring portion is exposed through the exposing portion of at least one of the upper- and lower-side covering portions, whereby the same can be easily electrically connected with the conductive member on the exposing portion.

In the aforementioned structure in which the second wiring portion is electrically connected with the conductive member through the exposing portion, the oscillating mirror element preferably includes a mirror portion reflecting the light and a shaft portion swingably supporting the mirror portion, and a pair of the exposing portions are preferably provided on an extension line of the axis of the shaft portion to hold the shaft portion and the mirror portion of the oscillating mirror element therebetween. According to this structure, the projector applies power across the pair of exposing portions provided on the extension line of the axis of the shaft portion through the second wiring portion, whereby the temperature of the conductive member can be efficiently increased along the axis. Consequently, the temperature of the shaft portion of the oscillating mirror element can be efficiently increased.

In the aforementioned structure in which the second wiring portion is electrically connected with the conductive member through the exposing portion, the second wiring portion of the wiring board is preferably electrically connected with the conductive member by a conductive connecting member through the exposing portion provided on the side of the lower-side covering portion. According to this structure, the conductive member and the second wiring portion can be electrically connected with each other through the exposing portion of the lower-side covering portion arranged therebetween, whereby connected portions of the conductive member and the second wiring portion as well as the connecting member can be prevented from outward exposure. Consequently, the device structure can be prevented from complication.

In the aforementioned structure in which the second wiring portion is electrically connected with the conductive member by the conductive connecting member through the exposing portion provided on the side of the lower-side covering portion, the connecting member preferably includes a conductive adhesive layer electrically connecting the second wiring portion and the conductive member with each other through the exposing portion and fixing the second wiring portion and the conductive member to each other. According to this structure, the wiring board and the conductive member can be bonded to each other and the second wiring portion and the conductive member can be electrically connected with each other through the conductive adhesive layer made of a conductive adhesive, silver paste or solder.

In the aforementioned structure in which the second wiring portion is electrically connected with the conductive member through the exposing portion, the second wiring portion of the wiring board is preferably electrically connected with the conductive member by a conductive connecting member through the exposing portion provided on the side of the upper-side covering portion. According to this structure, the second wiring portion can be exposed outward from the upper surface side (through the exposing portion provided on the side of the upper-side covering portion) on the conductive member through the exposing portion dissimilarly to a case where the exposing portion is arranged on the side of the lower-side covering portion, whereby the second wiring portion and the conductive member can be easily electrically connected with each other.

In the aforementioned structure in which the second wiring portion of the wiring board is electrically connected with the conductive member by the conductive connecting member through the exposing portion provided on the side of the upper-side covering portion, the connecting member preferably includes a plate spring electrically connecting the second wiring portion and the conductive member with each other by holding the upper surface of the second wiring portion and the lower surface of the conductive member through the exposing portion. According to this structure, the second wiring portion and the conductive member can be electrically connected with each other by simply holding the upper surface of the second wiring portion and the lower surface of the conductive member with the plate spring. Therefore, the electrical connection between the second wiring portion and the conductive member can be more easily ensured.

In the aforementioned structure in which the second wiring portion of the wiring board is electrically connected with the conductive member by the conductive connecting member through the exposing portion provided on the side of the upper-side covering portion, the connecting member preferably includes a screw electrically connecting the second wiring portion and the conductive member with each other by passing through the second wiring portion and fastening the second wiring portion and the conductive member to each other through the exposing portion. According to this structure, the second wiring portion and the conductive member are fastened to each other with the screw, whereby the second wiring portion and the conductive member can be electrically connected with each other and also fixed to each other.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic diagram showing a used state of an HUD device according to a first embodiment of the present invention in an automobile;
Fig. 2 is a block diagram showing a scanning block portion, scanning laser beams, of the HUD device according to the first embodiment of the present invention;
Fig. 3 is a perspective view showing the scanning block portion, scanning laser beams, of the HUD device according to the first embodiment of the present invention;
Fig. 4 is a perspective view showing the scanning block portion on a side horizontally scanning laser beams in the HUD device according to the first embodiment of the present invention;
Fig. 5 is a partially enlarged view showing a shaft portion of an MEMS mirror of the HUD device according to the first embodiment of the present invention;
Fig. 6 is an enlarged sectional view of a flexible wiring board and a conductive member taken along the line 500-500 in Fig. 4;
Fig. 7 is an enlarged sectional view of a flexible wiring board and a conductive member according to a second embodiment of the present invention;
Fig. 8 is an enlarged sectional view of a flexible wiring board and a conductive member according to a third embodiment of the present invention;
Fig. 9 is a perspective view showing a conductive member, an MEMS mirror and a flexible wiring board of an HUD device according to a fourth embodiment of the present invention; and
Fig. 10 is a perspective view showing the conductive member and the flexible wiring board of the HUD device according to the fourth embodiment of the present invention.

### DESCRIPTION OF THE PREFERRED EMBODIMENTS

Embodiments of the present invention are now described with reference to the drawings.

### (First Embodiment)

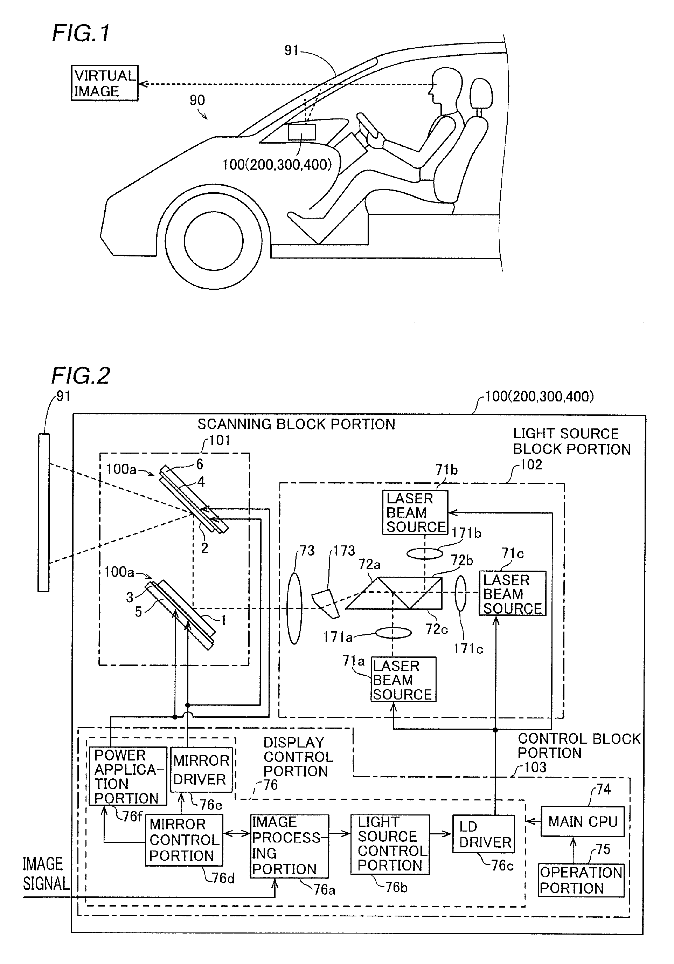

The structure of an HUD (headup display) device 100 according to a first embodiment of the present invention is described with reference to Figs. 1 to 6. The HUD device 100 is an example of the "projector" in the present invention.

As shown in Fig. 1, the HUD device 100 according to the first embodiment of the present invention is configured to be loaded on a transportation apparatus such as an automobile 90. The HUD device 100 is configured to apply laser beams to a screen 91 such as a windshield, thereby forming a virtual image (image) in front of the screen 91 on the outside of the automobile 90. The HUD device 100 has a function of displaying information related to car navigation, information related to the automobile 90 and the like on the screen 91. The laser beams are examples of the "light" in the present invention.

The HUD device 100 includes a scanning block portion 101, a light source block portion 102 and a control block portion 103, as shown in Fig. 2.

The scanning block portion 101 of the HUD device 100 includes MEMS mirrors 1 and 2 for horizontal scanning and vertical scanning. The scanning block portion 101 further includes flexible wiring boards 3 and 4 for driving the MEMS mirrors 1 and 2 respectively. The scanning block portion 101 further includes conductive members 5 supporting the MEMS mirrors 1 and 2 and the flexible wiring boards 3 and 4 respectively. The HUD device 100 constitutes an oscillating mirror element unit 100a with the MEMS mirror 1 (2), the conductive member 5 (6) and the flexible wiring board 3 (4). The MEMS mirrors 1 and 2 are examples of the "oscillating mirror element" in the present invention.

The MEMS mirror 1 is configured to scan applied laser beams in the horizontal direction (that of the screen) and to project the same on the screen 91 through the MEMS mirror 2. The MEMS mirror 2 is configured to scan the applied laser beams received from the MEMS mirror 1 in the vertical direction (that of the screen) and to project the same on the screen 91. More specifically, the MEMS mirrors 1 and 2 of the scanning block portion 101 are configured to successively scan laser beams emitted from laser beam sources 71a to 71c described later and to project an image on the screen 91. The MEMS mirror 1 is configured to scan the laser beams in the horizontal direction at a high speed by resonance driving. The MEMS mirror 2 is configured to scan the laser beams in the vertical direction at a low speed by DC driving.

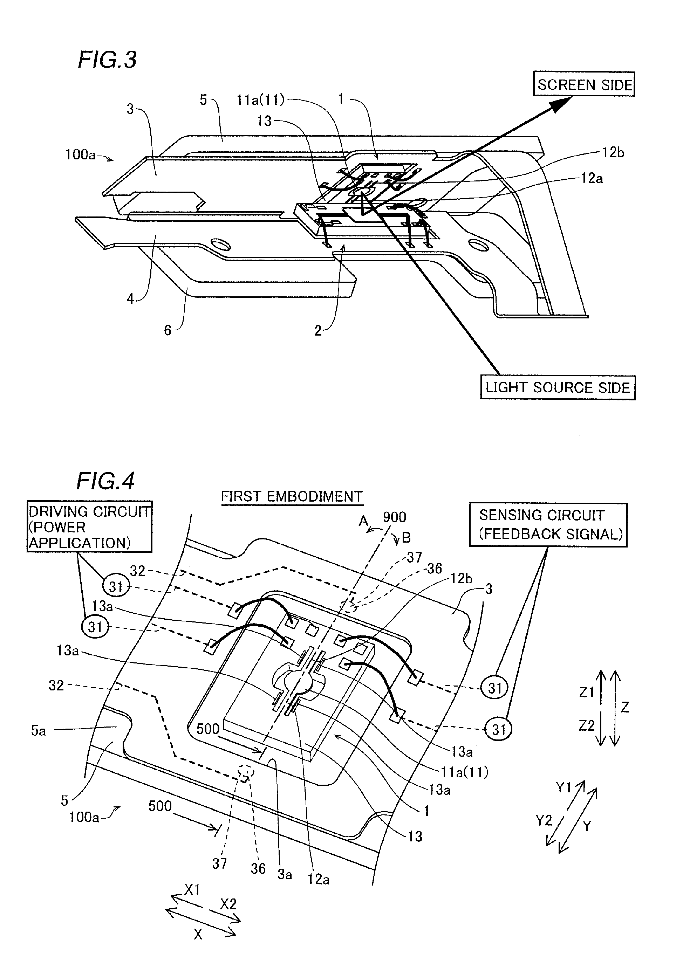

The HUD device 100 according to the first embodiment is configured to make the conductive members 5 and 6 generate heat by applying power to the respective ones of the conductive members 5 and 6 through the flexible wiring boards 3 and 4 (see Fig. 3). Further, the HUD device 100 is configured to increase the temperatures of the MEMS mirrors 1 and 2 supported by the conductive members 5 and 6 generating heat respectively. The details of the scanning block portion 101 are described later.

As shown in Fig. 4, each of the flexible wiring boards 3 and 4 includes driving wiring portions 31 transmitting driving signals and feedback signals to each of the MEMS mirrors 1 and 2 and a heat generation wiring portion 32 for making each of the conductive members 5 and 6 generate heat. The flexible wiring board 4 having a structure similar to that of the flexible wiring board 3 is not shown in Fig. 4. The HUD device 100 is configured to apply power to each of the conductive members 5 and 6 through the heat generation wiring portion 32. The driving wiring portions 31 are examples of the "first wiring portion" in the present invention. The heat generation wiring portion 32 is an example of the "second wiring portion" in the present invention.

As shown in Fig. 2, the light source block portion 102 of the HUD device 100 includes three (blue (B), green (G) and red (R)) laser beam sources 71a to 71c, three polarizing prisms 72a to 72c and a condensing lens 73. The light source block 102 further includes collimator lenses 171a to 171c parallelly correcting laser beams emitted from the laser beam sources 71a to 71c respectively. The light source block portion 102 also includes a beam shaping prism 173. The light source block portion 102 is configured to shape spots of the laser beams (from elliptic forms to substantially circular forms, for example) with light-emitting surfaces of the polarizing prism 72a and the beam shaping prism 173. The laser beam sources 71a to 71c are examples of the "light source portion" in the present invention.

The laser beam source 71a is configured to apply a green laser beam to the MEMS mirror 1 through the polarizing prism 72a. The laser beam source 71b is configured to apply a red laser beam to the MEMS mirror 1 successively through the polarizing prisms 72b and 72a. The laser beam source 71c is configured to apply a blue laser beam to the MEMS mirror 1 successively through the polarizing prisms 72c, 72b and 72c.

The HUD device 100 is so configured that respective components of the scanning block portion 101 and the light source block portion 102 are fixedly held on an optical base (not shown) in a state positioned thereon.

The control block portion 103 of the HUD device 100 includes a main CPU 74, an operation portion 75 and a display control portion 76.

The main CPU 74 is configured to control respective portions of the HUD device 100. The operation portion 75 is provided for accepting operations of turning on the HUD device 100, changing a projection angle of information, changing resolution of information and the like.

The display control portion 76 includes an image processing portion 76a, a light source control portion 76b, an LD (laser diode) driver 76c, a mirror control portion 76d, a mirror driver 76c and a power application portion 76f.

The HUD device 100 is configured to output image information on the basis of an image signal input in the image processing portion 76a. The image processing portion 76a is configured to control projection of an image on the basis of the externally input image signal. More specifically, the image processing portion 76a is configured to control driving of the MEMS mirrors 1 and 2 through the mirror control portion 76d and to control application of laser beams by the laser beam sources 71a to 71c through the light source control portion 76b on the basis of the externally input image signal.

The light source control portion 76b is configured to control application of laser beams by the laser beam sources 71a to 71c by controlling the LD driver 76c on the basis of control by the image processing portion 76a. More specifically, the light source control portion 76b is configured to control the laser beam sources 71a to 71c to emit laser beams of colors corresponding to respective pixels on the basis of image information in timing with scanning operations of the respective ones of the MEMS mirrors 1 and 2.

The mirror control portion 76d is configured to control the mirror driver 76e by transmitting a prescribed control signal thereto on the basis of control by the image processing portion 76a. The mirror control portion 76d is also configured to drive the MEMS mirrors 1 and 2 by transmitting driving signals thereto on the basis of the control signal received from the mirror control portion 76d. The power application portion 76f is configured to apply power to the conductive members 5 and 6 when the mirror driver 76e drives the MEMS mirrors 1 and 2 under control by the mirror control portion 76d.

The structure of the scanning block portion 101 (see Fig. 2) is now described in detail with reference to Figs. 3 to 6. The MEMS mirror 1 (including the flexible wiring board 3 and the conductive member 5) and the MEMS mirror 2 (including the flexible wiring board 4 and the conductive member 6) are similar in structure to each other, and hence the following description is made on the MEMS mirror 1, and redundant description is omitted as to the MEMS mirror 2.

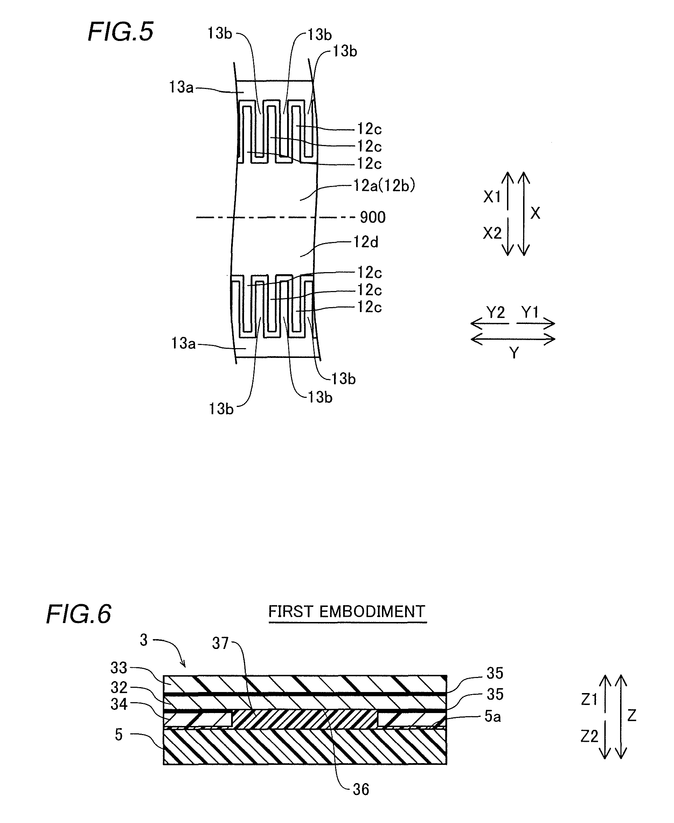

As shown in Figs. 3 and 4, the MEMS mirror 1 includes a mirror portion 11 reflecting laser beams, interdigital (see Fig. 5) shaft portions 12a and 12b driven to swing by electrostatic force for swingably supporting the mirror portion 11 and a support housing portion 13 supporting the shaft portions 12a and 12b. For the purpose of simplification, Figs. 3 and 4 illustrate the shaft portions 12a and 12b in the form of bars.

The mirror portion 11 has a reflecting surface 11a reflecting light on the side along arrow Z1. The mirror portion 11 is configured to be inclined (swung) by the shaft portions 12a and 12b in directions along arrows A and B around an axial line 900 (see Fig. 4). The axial line 900 is an example of the "axial line" in the present invention.

The shaft portions 12a and 12b are formed to extend in the direction along arrow Y. Inner end portions of the shaft portions 12a and 12b are connected to the mirror portion 11 respectively. The shaft portions 12a and 12b are so deformed as to couple the mirror portion 11 to be oscillable around the axial line 900 (see Fig. 4) respectively. As shown in Fig. 5, the shaft portion 12a (12b) has an interdigitally formed movable electrode portion 12d. More detailedly, the shaft portion 12a (12b) has a plurality of fine movable-side projecting portions 12c extending in directions along arrows X1 and X2. The plurality of movable-side projecting portions 12c are arranged to line up in the axial direction (along arrow Y) at regular intervals. The shaft portion 12a (12b) is interdigitally formed by the plurality of movable-side projecting portions 12c. Further, the shaft portion 12a (12b) is constituted of a silicon substrate covered with the movable electrode portion 12d of a metal film formed by etching. The movable electrode portion 12d is connected to the mirror driver 76e through the driving wiring portion 31 of the flexible wiring board 3.

As shown in Fig. 4, the support housing portion 13 is provided in the form of a box extending in the direction along arrow X. The support housing portion 13 fixedly supports outer end portions of the shaft portions 12a and 12b (end portions of the shaft portions 12a and 12b in the directions along arrows X2 and X1). The support housing portion 13 (the MEMS mirror 1) includes interdigitally formed fixed electrode portions 13a provided in the vicinity of the shaft portions 12a and 12b. More detailedly, the support housing portion 13 has pairs of fixed electrode portions 13a arranged to hold the shaft portion 12a (12b) therebetween. In other words, the MEMS mirror 1 two pairs of fixed electrode portions 13a on both sides of the mirror portion 11 along arrows Y1 and Y2 respectively. The fixed electrode portions 13a are interdigitally formed to correspond to the interdigital form of the shaft portion 12a (12b). More specifically, the fixed electrode portions 13a have a plurality of fine fixed-side projecting portions 13b extending toward the shaft portion 12a (12b) to penetrate into the spaces between the plurality of movable-side projecting portions 12c of the shaft portion 12a (12b), as shown in Fig. 5. The plurality of fixed-side projecting portions 13b are arranged to line up in the axial direction (along arrow Y) at regular intervals. The fixed electrode portions 13a are interdigitally formed by the plurality of fixed-side projecting portions 13b. Further, the fixed electrode portions 13a are connected to the mirror driver 76e through the driving wiring portion 31 of the flexible wiring board 3.

The mirror portion 11 (the shaft portion 12a (12b)) is configured to swing by electrostatic force generated between the movable electrode portions 12d and the fixed electrode portions 13a. More detailedly, the MEMS mirror 1 is configured to apply prescribed power to the movable electrode portions 12d and the fixed electrode portions 13a on the basis of a driving signal received from the mirror driver 76e through the driving wiring portion 31. Consequently, the MEMS mirror 1 is so configured that electrostatic attraction (electrostatic force) and electrostatic repulsion (electrostatic force) are alternately generated between the movable electrode portions 12d and the fixed electrode portions 13a. Thus, the MEMS mirror 1 is so configured that the shaft portions 12a and 12b are alternately swung in the directions along arrows A and B (see Fig. 4) thereby swinging the mirror portion 11.

The flexible wiring board 3 is configured to be arranged on an upper surface 5a (see Fig. 6) of the conductive member 5 in a contact state and to be supported by the conductive member 5. The flexible wiring board 3 has a rectangular hole portion 3a as shown in Fig. 4, and is so configured that the MEMS mirror 1 is arranged inside the hole portion 3a. Further, the flexible wiring board 3 includes upper- and lower-side covering portions 33 and 34 covering upper and lower sides (in the directions along arrows Z1 and Z2) of the heat generation wiring portion 32, as shown in Fig. 6. In other words, the upper-side covering portion 33 is arranged on a side of the heat generation wiring portion 32 opposite to the conductive member 5. The lower-side covering portion 34 is arranged on a side of the heat generation wiring portion 32 closer to the conductive member 5. The upper- and lower-side covering portions 33 and 34 are bonded to the upper and lower surfaces of the heat generation wiring portion 32 through adhesives 35 respectively.

As shown in Fig. 4, the flexible wiring board 3 includes a pair of exposing portions 36 exposing the heat generation wiring portion 32 not covered with the lower-side covering portion 34 on the lower side (in the direction along arrow Z2) of the heat generation wiring portion 32. The pair of exposing portions 36 are provided on extension lines of the axes of the shaft portions 12a and 12b, to hold the shaft portions 12a and 12b and the mirror portion 11 of the MEMS mirror 1 therebetween. The heat generation wiring portion 32 is electrically connected with (conducted to) the conductive member 5 through the pair of exposing portions 36. More specifically, the flexible wiring board 3 is so configured that a conductive adhesive 37 is charged into a region surrounded by the lower-side covering portion 34 and each exposing portion 36 thereby electrically connecting (conducting) the heat generation wiring portion 32 and the conductive member 5 with (to) each other through the conductive adhesive 37, as shown in Fig. 6. The conductive adhesive 37 further bonds the flexible wiring board 3 to the conductive member 5. The conductive adhesive 37 is an example of the "conductive adhesive layer" or the "connecting member" in the present invention.

As shown in Fig. 4, the pair of exposing portions 36 of the flexible wiring board 3 are formed on both sides (in the direction along arrow Y) of the MEMS mirror 1 on a position corresponding to the axial line 900 respectively, to hold the MEMS mirror 1 therebetween.

As shown in Fig. 3, the conductive member 5 is provided in the form of a rectangular flat plate. The conductive member 5 is made of conductive resin containing a conductive substance (carbon, graphite, ceramics or the like). Further, the conductive member 5 is connected to the power application portion 76f (see Fig. 2) through the heat generation wiring portion 32. The conductive members 5 and 6 are similar in structure to each other, except that the shapes thereof are different from each other.

As shown in Fig. 4, the conductive member 5 is so configured that positions corresponding to the interdigital shaft portions 12a and 12b generate heat when current flows to these portions. In other words, the conductive member 5 is so configured that current flows to the positions corresponding to the interdigital shaft portions 12a and 12b when the power application portion 76f applies power through the pair of exposing portions 36 of the flexible wiring board 3. Consequently, the conductive member 5 is so configured that temperatures of the positions corresponding to the interdigital shaft portions 12a and 12b are increased due to the current. Further, the conductive member 5 transfers the generated heat to the MEMS mirror 1 supported by the same. Thus, the conductive member 5 is configured to increase the temperature of the MEMS mirror 1.

According to the first embodiment, the following effects can be attained:
According to the first embodiment, as hereinabove described, the HUD device 100 is provided with the conductive member 5 for supporting the MEMS mirror 1 (2) and makes the conductive member 5 generate heat by applying power thereto. Thus, the HUD device 100 directly applies power to the conductive member 5, whereby no heating coil or the like may be separately provided. Consequently, the temperature of the MEMS mirror 1 (2) can be increased in a simple structure without complicating the structure for increasing the temperature thereof.

According to the first embodiment, as hereinabove described, the flexible wiring board 3 is provided with the driving wiring portion 31 connected to the MEMS mirror 1 (2) for transmitting the driving signal thereto and the heat generation wiring portion 32, and the HUD device 100 is configured to apply power to the conductive member 5 through the heat generation wiring portion 32 of the flexible wiring board 3. Thus, the HUD device 100 can transmit the driving signal to the MEMS mirror 1 (2) and apply power to the conductive member 5 with the single flexible wiring board 3 due to the provision of the heat generation wiring portion 32 on the flexible wiring board 3 including the existing driving wiring portion 31, whereby the temperature of the MEMS mirror 1 (2) can be increased in a simple structure without complicating the device structure, also according to this.

According to the first embodiment, as hereinabove described, the conductive member 5 is made of conductive resin containing a conductive substance. Thus, the conductive member 5 can be easily formed by resin molding.

According to the first embodiment, as hereinabove described, the MEMS mirror 1 (2) is provided with the mirror portion 11 reflecting light and the shaft portions 12a and 12b driven to swing by electrostatic force for swingably supporting the mirror portion 11, and the conductive member 5 is so configured that the positions corresponding to the shaft portions 12a and 12b generate heat when current flows to these portions. Thus, the conductive member 5 generates heat around prescribed positions corresponding to the shaft portions 12a and 12b of the MEMS mirror 1 (2), whereby the temperatures of the easily condensed shaft portions 12a and 12b of the MEMS mirror 1 (2) can be increased through the conductive member 5. Consequently, the shaft portions 12a and 12b can be effectively prevented from condensation.

According to the first embodiment, as hereinabove described, the MEMS mirror 1 (2) is provided with the interdigitally formed fixed electrode portions 13a provided in the vicinity of the shaft portions 12a and 12b, while each of the shaft portions 12a and 12b is configured to have the interdigitally formed movable electrode portion 12d and to swing due to electrostatic force generated between the movable electrode portion 12d and the fixed electrode portions 13a. In the electrostatically driven MEMS mirror 1 (2) having interdigital electrodes, the interdigits of the movable and fixed electrode portions 12d and 13a are arranged in proximity to each other, and hence the shaft portions 12a and 12b are more easily condensed as compared with an MEMS mirror driven by another system. Thus, the shaft portions 12a and 12b can be effectively prevented from condensation in the electrostatically driven MEMS mirror 1 (2), due to the aforementioned structure.

According to the first embodiment, as hereinabove described, the flexible wiring board 3 is arranged on the conductive member 5 and configured to be supported by the same, while the HUD device 100 is configured to apply power to the conductive member 5 through the heat generation wiring portion 32. Thus, the conductive member 5 supports the flexible wiring board 3, whereby the flexible wiring board 3 can be stably arranged with respect to the MEMS mirror 1 (2), and the HUD device 100 can easily apply power to the conductive member 5 provided in close vicinity to the flexible wiring board 3 through the heat generation wiring portion 32 of the flexible wiring board 3.

According to the first embodiment, as hereinabove described, the flexible wiring board 3 is provided with the upper- and lower-side covering portions 33 and 34 covering the upper and lower sides (in the directions along arrows Z1 and Z2) of the heat generation wiring portion 32 and the exposing portions 36 exposing the heat generation wiring portion 32 not covered with the lower-side covering portion 34, and the heat generation wiring portion 32 is electrically connected with the conductive member 5 through the exposing portions 36. Thus, the heat generation wiring portion 32 is exposed from the exposing portions 36 provided on the side of the lower-side covering portion 34, whereby the heat generation wiring portion 32 and the conductive member 5 can be easily electrically connected with each other through the exposing portions 36.

According to the first embodiment, as hereinabove described, the MEMS mirror 1 (2) is provided with the mirror portion 11 reflecting light and the shaft portions 12a and 12b swingably supporting the mirror portion 11, and the pair of exposing portions 36 are provided on the extension lines of the axes of the shaft portions 12a and 12b to hold the shaft portions 12a and 12b and the mirror portion 11 of the MEMS mirror 1 (2) therebetween. Thus, the HUD device 100 applies power across the pair of exposing portions 36 provided on the extension lines of the axes of the shaft portions 12a and 12b through the heat generation wiring portion 32, whereby the temperature of the conductive member 5 can be efficiently increased along the axial line 900. Consequently, the temperatures of the shaft portions 12a and 12b of the MEMS mirror 1 (2) can be efficiently increased.

According to the first embodiment, as hereinabove described, the heat generation wiring portion 32 of the flexible wiring board 3 is electrically connected with the conductive member 5 with the conductive adhesive 37 through the exposing portions 36 provided on the side of the lower-side covering portion 34. Thus, the conductive member 5 and the heat generation wiring portion 32 can be electrically connected with each other through the exposing portions 36 of the lower-side covering portion 34 arranged therebetween, whereby connected portions of the conductive member 5 and the heat generation wiring portion 32 as well as the conductive adhesive 37 can be prevented from outward exposure. Consequently, the device structure can be prevented from complication.

According to the first embodiment, as hereinabove described, the conductive adhesive 37 is so provided as to electrically connect the heat generation wiring portion 32 and the conductive member 5 with each other through the exposing portions 36 and to fix the heat generation wiring portion 32 and the conductive member 5 to each other. Thus, the conductive adhesive 37 can bond the flexible wiring board 3 and the conductive member 5 to each other and electrically connect the heat generation wiring portion 32 and the conductive member 5 with each other.

### (Second Embodiment)

A second embodiment of the present invention is now described with reference to Figs. 1, 2 and 7. According to the second embodiment, a plate spring 237 electrically connects a heat generation wiring portion 32 of a flexible wiring board 203 and a conductive member 5 with each other, dissimilarly to the aforementioned first embodiment employing the conductive adhesive 37 for electrically connecting the heat generation wiring portion 32 of the flexible wiring board 3 and the conductive member 5 with each other. Structures of the second embodiment similar to those of the aforementioned first embodiment are shown by the same reference signs, and redundant description thereof is omitted. The plate spring 237 is an example of the "connecting member" in the present invention.

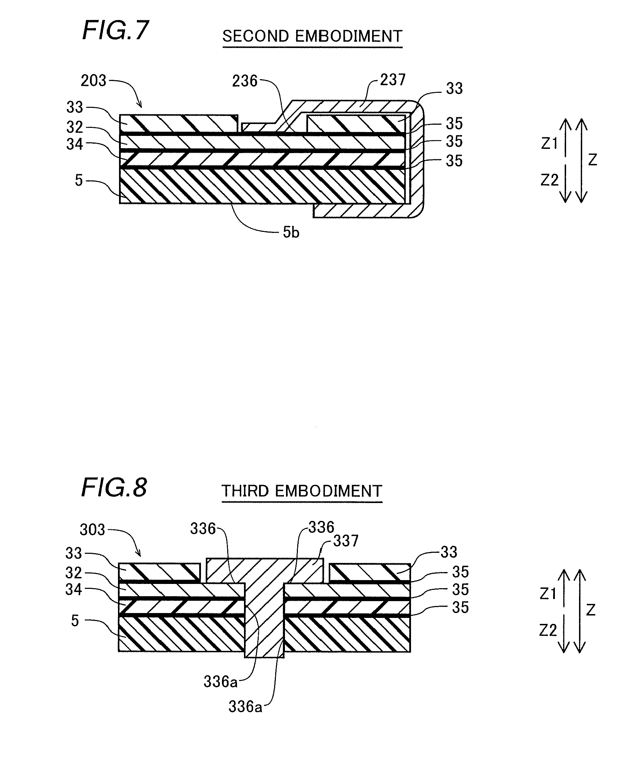

In an HUD device 200 (see Figs. 1 and 2) according to the second embodiment, the flexible wiring board 203 is bonded to the conductive member 5 with adhesives 35, as shown in Fig. 7. The flexible wiring board 203 includes a pair of exposing portions 236 exposing the heat generation wiring portion 32 not covered with an upper-side covering portion 33 on the upper side (in the direction along arrow Z1) of the heat generation wiring portion 32. The heat generation wiring portion 32 of the flexible wiring board 203 is electrically connected with the conductive member 5 by the conductive plate spring 237 through the exposing portions 236 provided on the side of the upper-side covering portion 33. More specifically, the plate spring 237 is configured to electrically connect the heat generation wiring portion 32 and the conductive member 5 with each other by holding the upper surface of the heat generation wiring portion 32 and a lower surface 5b (the surface in the direction along arrow Z2) of the conductive member 5 through the exposing portions 237. That is, the plate spring 237 is so configured that a first end thereof comes into contact with the exposing portions 236 provided on the upper side (in the direction along arrow Z1) of the heat generation wiring portion 32 and a second end thereof comes into contact with the lower surface 5b (in the direction along arrow Z2) of the conductive member 5. In other words, the plate spring 237 is so mounted as to hold the flexible wiring board 203 and the conductive member 5. Thus, the flexible wiring board 203 and the conductive member 5 are electrically connected with each other. The HUD device 200 is an example of the "projector" in the present invention.

The remaining structures of the second embodiment are similar to those of the aforementioned first embodiment.

According to the second embodiment, the following effects can be attained:
According to the second embodiment, the HUD device 200 is provided with the conductive member 5 for supporting an MEMS mirror 1 (2) and makes the conductive member 5 generate heat by applying power thereto, similarly to the aforementioned first embodiment. Thus, the HUD device 200 directly applies power to the conductive member 5, whereby the temperature of the MEMS mirror 1 (2) can be increased in a simple structure.

According to the second embodiment, as hereinabove described, the heat generation wiring portion 32 of the flexible wiring board 203 is electrically connected with the conductive member 5 by the conductive plate spring 237 through the exposing portions 236 provided on the side of the upper-side covering portion 33. Thus, the heat generation wiring portion 32 can be exposed outward from the upper surface side (through the exposing portions 236 provided on the side of the upper-side covering portion 33) on the conductive member 5 dissimilarly to the case where the exposing portions are arranged on the side of the lower-side covering portion, whereby the heat generation wiring portion 32 and the conductive member 5 can be easily electrically connected with each other.

According to the second embodiment, as hereinabove described, the HUD device 200 is provided with the plate spring 237 for electrically connecting the heat generation wiring portion 32 and the conductive member 5 with each other by holding the upper surface of the heat generation wiring portion 32 and the lower surface 5b of the conductive member 5 through the exposing portions 236. Thus, the heat generation wiring portion 32 and the conductive member 5 can be electrically connected with each other by simply holding the upper surface of the heat generation wiring portion 32 and the lower surface 5b of the conductive member 5 with the plate spring 237. Therefore, the electrical connection between the heat generation wiring portion 32 and the conductive member 5 can be more easily ensured.

The remaining effects of the second embodiment are similar to those of the aforementioned first embodiment.

### (Third Embodiment)

A third embodiment of the present invention is now described with reference to Figs. 1, 2 and 8. According to the third embodiment, a conductive screw 337 electrically connects a heat generation wiring portion 32 of a flexible wiring board 303 and a conductive member 5 with each other, dissimilarly to the aforementioned second embodiment employing the plate spring 237 for electrically connecting the heat generation wiring portion 32 of the flexible wiring board 203 and the conductive member 5 with each other. Structures of the third embodiment similar to those of the aforementioned second embodiment are shown by the same reference signs, and redundant description thereof is omitted. The screw 337 is an example of the "connecting member" in the present invention.

In an HUD device 300 (see Figs. 1 and 2) according to the third embodiment, the flexible wiring board 303 is bonded to the conductive member 5 with adhesives 35, as shown in Fig. 8. The flexible wiring board 303 includes a pair of exposing portions 336 exposing the heat generation wiring portion 32 not covered with an upper-side covering portion 33 on the upper side (in the direction along arrow Z1) of the heat generation wiring portion 32. The flexible wiring board 303 and the conductive member 5 are provided with threaded holes 336a extending from the exposing portions 336 in the direction along arrow Z2 respectively. The screw 337 is fitted into the threaded holes 336a, thereby electrically connecting the heat generation wiring portion 32 and the conductive member 5 with each other. In other words, the screw 337 is configured to electrically connect the heat generation wiring portion 32 and the conductive member 5 with each other by passing through the heat generation wiring portion 32 and fastening the heat generation wiring portion 32 to the conductive member 5 through the exposing portions 336. The screw 337 is mounted on the flexible wiring board 303 and the conductive member 5 in a state where a head portion thereof is in contact with the exposing portions 336. The HUD device 300 is an example of the "projector" in the present invention.

The remaining structures of the third embodiment are similar to those of the aforementioned second embodiment.

According to the third embodiment, the following effects can be attained.

According to the third embodiment, the HUD device 300 is provided with the conductive member 5 for supporting an MEMS mirror 1 (2) and makes the conductive member 5 generate heat by applying power thereto, similarly to the aforementioned second embodiment. Thus, the HUD device 300 directly applies power to the conductive member 5, whereby the temperature of the MEMS mirror 1 (2) can be increased in a simple structure.

According to the third embodiment, as hereinabove described, the HUD device 300 is provided with the screw 337 for electrically connecting the heat generation wiring portion 32 and the conductive member 5 with each other by passing through the heat generation wiring portion 32 and fastening the heat generation wiring portion 32 to the conductive member 5 through the exposing portions 336. Thus, the screw 337 fastens the heat generation wiring portion 32 and the conductive member 5 to each other, whereby the same can fix the heat generation wiring portion 32 and the conductive member 5 to each other while electrically connecting the same with each other.

The remaining structures of the third embodiment are similar to those of the aforementioned second embodiment.

### (Fourth Embodiment)

A fourth embodiment of the present invention is now described with reference to Figs. 1, 2, 9 and 10. According to the fourth embodiment, a lower surface 5b (the surface in the direction along arrow Z2) of a conductive member 405 on a position corresponding to an MEMS mirror 1 is formed by a planar portion 451 and recess portions 452, dissimilarly to the aforementioned first embodiment in which the lower surface 5b (in the direction along arrow Z2) of the conductive member 5 on the position corresponding to the MEMS mirror 1 is planarly formed in plan view (as viewed along arrow Z2). Structures of the fourth embodiment similar to those of the aforementioned first embodiment are shown by the same reference signs, and redundant description thereof is omitted.

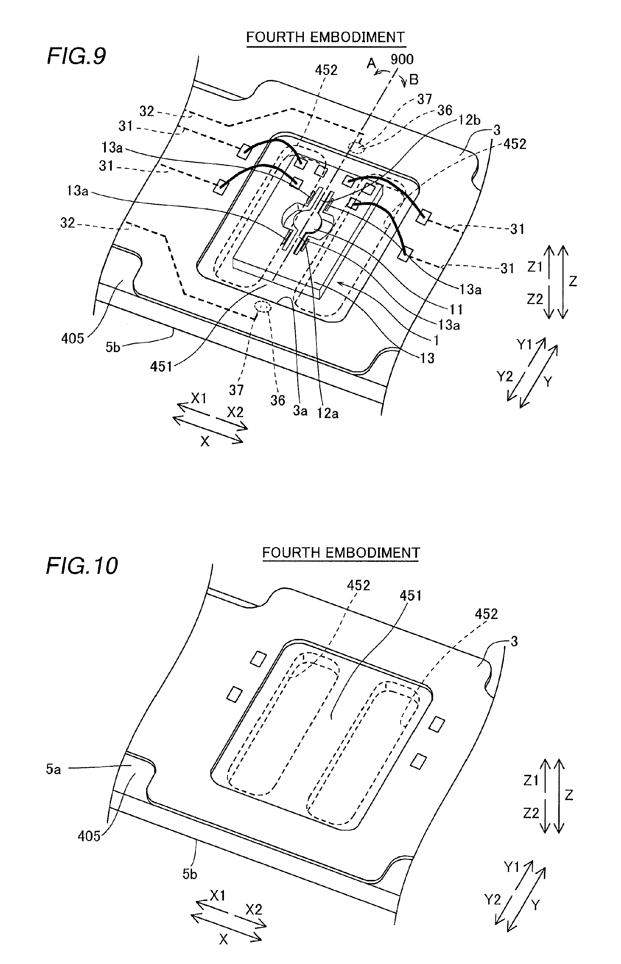

In an HUD device 400 (see Figs. 1 and 2) according to the fourth embodiment, the conductive member 405 is provided with the planar portion 451 and the recess portions 452 smaller in thickness than the planar portion 451 on a region corresponding to a position where the MEMS mirror 1 is arranged in plan view (as viewed from the direction along arrow Z2), as shown in Figs. 9 and 10. The planar portion 451 is arranged on a position superposing with shaft portions 12a and 12b, and formed to extend in an axial direction (along arrow Y) along the shaft portions 12a and 12b. The recess portions 452 are formed to extend in the axial direction (along arrow Y), and arranged on both sides of the planar portion 451 adjacently thereto, to hold the planar portion 451 therebetween. The thickness of the conductive member 405 is smaller in the recess portions 452 than in the planar portion 451. For example, the thickness of the conductive member 405 is set to about 1 mm in the planar portion 451, and set to about 0.5 mm in the recess portions 451. The HUD device 400 is an example of the "projector" in the present invention.

The remaining structures of the fourth embodiment are similar to those of the aforementioned first embodiment.

According to the fourth embodiment, the following effects can be attained:
According to the fourth embodiment, the HUD device 400 is provided with the conductive member 405 for supporting the MEMS mirror 1 (2) and makes the conductive member 5 generate heat by applying power thereto, similarly to the aforementioned first embodiment. Thus, the HUD device 400 directly applies power to the conductive member 405, whereby the temperature of the MEMS mirror 1 (2) can be increased in a simple structure.

According to the fourth embodiment, as hereinabove described, the planar portion 451 is formed on the region of the conductive member 405 corresponding to the position where the shaft portions 12a and 12b of the MEMS mirror 1 (2) are arranged in plan view, the recess portions 452 are formed on the regions of the conductive member 405 adjacent to the planar portion 451 in plan view, and the thickness of the conductive member 405 is rendered smaller in the recess portions 452 than in the planar portion 451. Thus, the sectional area orthogonal to the shaft portions 12a and 12b is larger (electric resistance is smaller) in the planar portion 451 as compared with the recess portions 452, whereby current easily flows to the planar portion 451 of the conductive member 405 corresponding to the shaft portions 12a and 12b of the MEMS mirror 1 (2), and the temperatures of the shaft portions 12a and 12b of the MEMS mirror 1 (2) can be efficiently increased.

According to the fourth embodiment, as hereinabove described, the planar portion 451 is formed to extend in the axial direction along the shaft portions 12a and 12b, while the recess portions 452 are formed to extend in the axial direction and arranged on both sides of the planar portion 451 adjacently thereto to hold the planar portion 451 therebetween. Thus, the recess portions 452 are arranged on both sides of the planar portion 451, whereby the temperatures of the shaft portions 12a and 12b of the MEMS mirror 1 (2) can be more efficiently increased as compared with a case where a single recess portion 452 is arranged on one side of the planar portion 451.

The remaining effects of the fourth embodiment are similar to those of the aforementioned first embodiment.

Although the present invention has been described and illustrated in detail, it is clearly understood that the present invention being limited only by the terms of the appended claims.

For example, while the present invention is applied to the HUD device in each of the aforementioned first to fourth embodiments, the present invention may alternatively be applied to a projector other than the HUD device.

While the conductive member and the flexible wiring board are electrically connected with each other by the conductive adhesive, the plate spring or the screw in each of the aforementioned first to fourth embodiments, the present invention is not restricted to this. According to the present invention, the conductive member and the flexible wiring board may alternatively be electrically connected with each other by solder or silver paste, for example.

While the HUD device applies power to the conductive member through the flexible wiring board in each of the aforementioned first to fourth embodiments, the present invention is not restricted to this. According to the present invention, the HUD device may be provided with an electrode for applying power to the conductive member thereby applying power to the conductive member, for example.

While the conductive member is made of conductive resin containing a conductive substance in each of the aforementioned first to fourth embodiments, the present invention is not restricted to this. According to the present invention, the conductive member may alternatively be made of metal, for example.

While the flexible wiring board is electrically connected with the conductive member through the exposing portions exposing the heat generation wiring portion from the upper- or lower-side covering portion of the flexible wiring board in each of the aforementioned first to fourth embodiments, the present invention is not restricted to this. According to the present invention, the flexible wiring board may alternatively be electrically connected with the conductive member through the heat generation wiring portion exposed from an end portion of the flexible wiring board, for example.

While the scanning portions for horizontal scanning and vertical scanning are provided separately from each other in each of the aforementioned first to fourth embodiments, the present invention is not restricted to this. According to the present invention, a single scanning portion for horizontal scanning and vertical scanning may alternatively be provided.

## Claims

1. A projector (100, 200, 300, 400) comprising:
a light source portion (71a, 71b, 71c) applying light;
an oscillating mirror element (1, 2) scanning the light; and
a conductive member (5, 6, 405) supporting the oscillating mirror element, and
making the conductive member generate heat by applying power to the conductive member.

2. The projector according to claim 1, further comprising a wiring board (3, 4, 203, 303), electrically connected to the oscillating mirror element, including a first wiring portion (31) transmitting a driving signal to the oscillating mirror element and a second wiring portion (32) different from the first wiring portion, and
applying power to the conductive member through the second wiring portion of the wiring board.

3. The projector according to claim 1 or 2, wherein
the conductive member is made of conductive resin containing a conductive substance.

4. The projector according to any of claims 1 to 3, wherein
the oscillating mirror element includes a mirror portion (11) reflecting the light and a shaft portion (12a, 12b) swingably supporting the mirror portion, and
a position of the conductive member corresponding to the shaft portion generates heat when current flows to the position corresponding to the shaft portion.

5. The projector according to claim 4, wherein
the oscillating mirror element includes an interdigitally formed fixed electrode portion (13a) provided in the vicinity of the shaft portion, and
the shaft portion has an interdigitally formed movable electrode portion (12d), and swings due to electrostatic force generated between the movable electrode portion and the fixed electrode portion.

6. The projector according to claim 4 or 5, wherein
a planar portion (451) is formed on a region of the conductive member corresponding to a position where the shaft portion of the oscillating mirror element is arranged in plan view, and recess portions (452) are formed on regions adjacent to the planar portion in plan view, and
the thickness of the conductive member in the recess portions is smaller than the thickness of the conductive member in the planar portion.

7. The projector according to claim 6, wherein
the planar portion is formed to extend in an axial direction along the shaft portion, and
the recess portions are formed to extend in the axial direction, and arranged on both sides of the planar portion adjacently to the planar portion to hold the planar portion therebetween.

8. The projector according to any of claims 1 to 7, further comprising a wiring board (3, 4, 203, 303), electrically connected to the oscillating mirror element, including a first wiring portion (31) transmitting a driving signal to the oscillating mirror element and a second wiring portion (32) different from the first wiring portion, wherein
the wiring board is arranged on the conductive member and supported by the conductive member, and
the projector applies power to the conductive member through the second wiring portion of the wiring board.

9. The projector according to claim 8, wherein
the wiring board includes an upper-side covering portion (33) covering an upper side of the second wiring portion, a lower-side covering portion (34) arranged on a side of the second wiring portion closer to the conductive member for covering a lower side of the second wiring portion and an exposing portion (36, 236, 336) exposing the second wiring portion not covered with at least one of the upper-side covering portion and the lower-side covering portion, and
the second wiring portion is electrically connected with the conductive member through the exposing portion.

10. The projector according to claim 9, wherein
the oscillating mirror element includes a mirror portion (11) reflecting the light and a shaft portion (12a, 12b) swingably supporting the mirror portion, and
a pair of the exposing portions are provided on an extension line of the axis of the shaft portion to hold the shaft portion and the mirror portion of the oscillating mirror element therebetween.

11. The projector according to claim 9 or 10, wherein
the second wiring portion of the wiring board is electrically connected with the conductive member by a conductive connecting member (37) through the exposing portion provided on the side of the lower-side covering portion.

12. The projector according to claim 11, wherein
the connecting member includes a conductive adhesive layer (37) electrically connecting the second wiring portion and the conductive member with each other through the exposing portion and fixing the second wiring portion and the conductive member to each other.

13. The projector according to claim 9 or 10, wherein
the second wiring portion of the wiring board is electrically connected with the conductive member by a conductive connecting member (237, 337) through the exposing portion provided on the side of the upper-side covering portion.

14. The projector according to claim 13, wherein
the connecting member includes a plate spring (237) electrically connecting the second wiring portion and the conductive member with each other by holding the upper surface of the second wiring portion and the lower surface (5b) of the conductive member through the exposing portion.

15. The projector according to claim 13, wherein
the connecting member includes a screw (337) electrically connecting the second wiring portion and the conductive member with each other by passing through the second wiring portion and fastening the second wiring portion and the conductive member to each other through the exposing portion.
